(19) Europäisches Patentamt
European Patent Office
Office européen des brevets

(11) **EP 1 317 793 B1**

(12) **EUROPÄISCHE PATENTSCHRIFT**

(45) Veröffentlichungstag und Bekanntmachung des Hinweises auf die Patenterteilung:
**06.05.2004 Patentblatt 2004/19**

(21) Anmeldenummer: **01974027.3**

(22) Anmeldetag: **06.09.2001**

(51) Int Cl.$^7$: **H02M 3/07**

(86) Internationale Anmeldenummer:
**PCT/DE2001/003427**

(87) Internationale Veröffentlichungsnummer:
**WO 2002/023706 (21.03.2002 Gazette 2002/12)**

(54) **LADUNGSPUMPENSCHALTUNG**

CHARGE PUMP CIRCUIT

CIRCUIT A POMPE DE CHARGE

(84) Benannte Vertragsstaaten:
**DE FR IT SE**

(30) Priorität: **15.09.2000 DE 10045693**

(43) Veröffentlichungstag der Anmeldung:
**11.06.2003 Patentblatt 2003/24**

(73) Patentinhaber: **Infineon Technologies AG**
**81669 München (DE)**

(72) Erfinder: **AUSSERLECHNER, Udo**
**9500 Villach (AT)**

(74) Vertreter: **Epping Hermann & Fischer**
**Ridlerstrasse 55**
**80339 München (DE)**

(56) Entgegenhaltungen:
**EP-A- 0 630 051  DD-A- 223 031**
**DE-A- 2 621 694  US-A- 5 059 815**
**US-A- 5 066 871  US-A- 5 612 828**

- **PATENT ABSTRACTS OF JAPAN vol. 2000, no. 11, 3. Januar 2001 (2001-01-03) & JP 2000 236657 A (NEC KYUSHU LTD), 29. August 2000 (2000-08-29)**
- **PATENT ABSTRACTS OF JAPAN vol. 2000, no. 09, 13. Oktober 2000 (2000-10-13) & JP 2000 175441 A (NEC CORP), 23. Juni 2000 (2000-06-23)**

**Beschreibung**

Die vorliegende Erfindung betrifft eine Ladungspumpenschaltung.

Ladungspumpenschaltungen dienen zur Bereitstellung einer Ausgangsspannung, welche größer als eine der Ladungspumpenschaltung zuführbare Versorgungsspannung ist.

In elektronischen Systemen ist es oft erforderlich, eine Versorgungsspannung für Schaltungsteile bereitzustellen, welche höher als die eigentliche Betriebsspannung des elektronischen Systems ist. Hierfür können Ladungspumpenschaltungen verwendet werden.

In der Druckschrift US 5,066,871 ist das Prinzip einer Ladungspumpenschaltung sowie eine Realisierung zum einen mit CMOS-Technologie und zum anderen in Bipolar-Schaltungstechnik angegeben. Dort ist ein Kondensator vorgesehen, der mit seinen Anschlüssen einerseits an ein Versorgungspotential angeschlossen und andererseits umschaltbar an Masse oder das Versorgungspotential anschließbar ist.

In der Druckschrift US 5,059,815 ist eine in CMOS-Technik aufgebaute Ladungspumpenschaltung angegeben, welche eine Kaskadenstruktur aufweist. Dabei sind zwei Ladungspumpenschaltungen, welche jeweils als Ladungsspeicher einen Kondensator in Serie zu einer Kapazitätsdiode umfassen, hintereinandergeschaltet. Diese Schaltung ist jedoch nur für kleine Spannungen geeignet, wenn Standard-CMOS-Bauteile verwendet werden.

CMOS(Complementary-Metal-Oxyd-Semiconductor)-Technologie zur Realisierung von Ladungspumpenschaltungen, beispielsweise in der Automobiltechnik, hat den Nachteil, daß derartige Ladungspumpenschaltungen verhältnismäßig schlechte Durchbruchseigenschaften bei gelegentlich auftretenden Spannungsspitzen aufweisen.

Die in der Druckschrift US 5,066,871 angegebene in Bipolar-Technik aufgebaute Ladungspumpenschaltung ist bezüglich auftretender Spannungsspitzen verbessert, weist jedoch den Nachteil auf, daß aufgrund von Sättigungseffekten, welche in Bipolar-Transistoren üblicherweise vorkommen können, kein schnelles Abschalten bzw. keine schnellen Schaltzeiten bei der Ladungspumpenschaltung möglich sind. Es ist eine Schaltung angegeben, welche lediglich eine besonders starke Sättigung der NPN-Transistoren in der Ladungspumpenschaltung vermeidet.

In dem Dokument DE 2621694 ist eine Spannungsverdopplungsschaltung mit einem Eingang und einem Ausgang sowie mit zwei Dioden, zwei Ladungsspeichern und zwei Schaltungstransistoren angegeben, die derart miteinander verschaltet sind, daß die Ausgangsspannung ungefähr der doppelten Eingangsspannung entspricht. Die Spannungsfestigkeit der eingesetzten Ladungsspeicher muß dabei größer sein als die Eingangsspannung.

Aufgabe der vorliegenden Erfindung ist es, eine Ladungspumpenschaltung anzugeben, welche eine Spannung bereit stellt, die größer als die Summe der Spannungsfestigkeiten der eingesetzten Ladungsspeicher ist.

Erfindungsgemäß wird die Aufgabe mit einer Ladungspumpenschaltung zur Bereitstellung einer Ausgangsspannung gelöst, welche größer als ihre Versorgungsspannung ist, aufweisend

- einen ersten Ladungsspeicher, der einerseits über eine erste Diode mit einem Anschluß zur Zuführung einer Eingangsspannung und andererseits mit einem Schaltungsknoten gekoppelt ist,
- einen zweiten Ladungsspeicher, der einerseits mit einem Anschluß zur Zuführung des Versorgungspotentials und andererseits über eine zweite Diode mit dem ersten Ladungsspeicher gekoppelt, und mit einem Anschluß zur Bereitstellung der Ausgangsspannung verbunden ist,
- ein erstes Schaltmittel, welches einerseits mit dem Versorgungspotentialanschluß und andererseits mit dem Schaltungsknoten gekoppelt ist und
- ein zweites Schaltmittel, welches einerseits mit einem Anschluß für ein Bezugspotential und andererseits mit dem Schaltungsknoten verbunden ist,
- wobei erstes und zweites Schaltmittel Bipolar-Transistoren umfassen und zu deren Steuerung mit einem Anschluß zur Zuführung eines Hochfrequenz-Signals gekoppelt sind.

Die Versorgungsspannung ist die Spannungsdifferenz zwischen Versorgungspotential und Bezugspotential.

Die Eingangsspannung der Ladungspumpenschaltung liegt üblicherweise im Bereich einiger Volt. Folglich kann der erste Ladungsspeicher als Kapazität, welche eine geringe Spannungsfestigkeit hat, ausgelegt sein. Der zweite Ladungsspeicher erfährt ebenfalls eine geringe spannungsmäßige Belastung, da über dem zweiten Ladungsspeicher lediglich die Differenzspannung von Ausgangsspannung und Versorgungsspannung abfällt. Die Ladungsspeicher können folglich mit geringem Flächen- und Strombedarf realisiert bzw. betrieben werden. Zudem sind aufgrund der geringen Spannungsbelastung der Ladungsspeicher hohe Ausfallsicherheiten derselben, verursacht durch Überspannungsspitzen in der Versorgungsspannung, zu erwarten. Beispielsweise bei Einsatz der Ladungspumpenschaltung in Anwendungen der Automobiltechnik sind starke Spannungsspitzen und - schwankungen der Versorgungsspannung beispielsweise aufgrund von Start-, Überbrückungs- oder Schaltvorgängen an einem Kraftfahrzeug zu erwarten. Die beschriebene Ladungspumpenschaltung kann eine Ausgangsspannung erzeugen, welche größer ist als die Spannungsfestigkeit der einzelnen Ladungsspeicher. Die Ausgangsspannung entspricht ungefähr der Summe aus Eingangsspannung und Versorgungsspannung.

Die Eingangsspannung ist bevorzugt kleiner als die Versorgungsspannung.

Beispielsweise kann die Eingangsspannung 4 V betragen, die Versorgungsspannung 25 V. Dann kann vorliegende Schaltung eine Ausgangsspannung von ca. 28 V bereitstellen, obwohl im vorliegenden Beispiel die beiden Ladungsspeicher lediglich eine Spannungsfestigkeit von 12 V haben.

In einer vorteilhaften Ausführungsform der vorliegenden Erfindung ist je eine Diode vorgesehen, welche in Durchlaßrichtung zwischen dem Anschluß für die Eingangsspannung und dem ersten Ladungsspeicher bzw. zwischen dem ersten Ladungsspeicher und dem zweiten Ladungsspeicher angeschlossen ist. Die Dioden ermöglichen eine einfache Realisierung einer Aufladung des ersten Ladungsspeichers mit der Eingangsspannung während einer ersten Taktphase und die Umladung der im ersten Ladungsspeicher gespeicherten Ladung in den zweiten Ladungsspeicher während einer zweiten Taktphase.

In einer weiteren, bevorzugten Ausführungsform der vorliegenden Erfindung umfassen erstes und zweites Schaltmittel jeweils einen Bipolar-Transistor, an dem je eine erste bzw. zweite Anti-Sättigungsschaltung angeschlossen ist. Bei der Verwendung von Bipolar-Transistoren zum Umschalten zwischen erster und zweiter Taktphase der Ladungspumpenschaltung vermeiden Anti-Sättigungsschaltungen, daß die Bipolar-Transistoren in Sättigung gehen und somit kann der Stromverbrauch der Schaltung reduziert und die mit dem Hochfrequenzsignal zuführbare Pumpfrequenz erhöht werden.

In einer weiteren, vorteilhaften Ausführungsform der vorliegenden Erfindung ist an die Steuereingänge der Bipolar-Transistoren eine Ansteuerschaltung angeschlossen, der das Hochfrequenzsignal zuführbar ist zum abwechselnden Einschalten der als Schaltverstärker ausgelegten Bipolar-Transistoren. Wenn das Hochfrequenzsignal ein Rechtecksignal ist, so kann während einer ersten Taktphase des Rechtecksignals der erste Bipolar-Transistor ein- und der zweite Bipolar-Transistor ausgeschaltet sein und während der zweiten Taktphase umgekehrt.

In einer weiteren, vorteilhaften Ausführungsform der vorliegenden Erfindung ist ein Mittel zum Schutz der Ansteuerschaltung vor hohen Spannungen vorgesehen, welchem an einem Steuereingang eine Hilfsspannung zuführbar ist und welches die Ansteuerschaltung mit dem Anschluß für die Versorgungsspannung verbindet. Zur Realisierung des Mittels zum Schutz vor hohen Spannungen kann lediglich ein hochvolt-fester Bipolar-Transistor ausreichen, wodurch sichergestellt ist, daß potentialmäßig darunter liegende Schaltungsteile, beispielsweise Schalter und Stromquellen der Ansteuerschaltung, mit Strom sparenden und Flächen sparenden Standard-CMOS-Bauelementen realisiert werden können. Dies kann beispielsweise bei Einsatz der Ladungspumpenschaltung in für Überspannungen anfälligen Applikationen, beispielsweise im Automobilbereich, vorteilhaft sein.

In einer weiteren, vorteilhaften Ausführungsform der vorliegenden Erfindung umfassen die Anti-Sättigungsschaltungen je zwei gegeneinander geschaltete Dioden, welche zwischen Basisund Kollektoranschluß der Bipolar-Transistoren der Schaltmittel angeschlossen sind, wobei die Dioden jeweils in ihrem Verbindungsknoten mit der Ansteuerschaltung verbunden sind. Hierdurch wird vermieden, daß die in Emitterschaltung betriebenen Bipolar-Transistoren eine negative Kollektor-Basis-Spannung haben. Folglich wird nicht nur eine tiefe Sättigung der Transistoren, sondern bereits eine leichte Sättigung der Transistoren vermieden. Dies ermöglicht zum einen eine hohe Pumpfrequenz und zum anderen reduziert eine derartige, effektive Sättigungsschaltung den Stromverbrauch der Ladungspumpenschaltung um das Produkt aus der Sättigungsladung und der Pumpfrequenz. Das gleichzeitig vermiedene Injizieren von Substratstrom, insbesondere bei hohen Temperaturen, reduziert den Stromverbrauch der Schaltung weiter. Die Dioden können teilweise durch Widerstände oder durch weitere Transistoren ersetzt werden. Jede der Dioden kann durch eine Serienschaltung aus mehreren Dioden ersetzt werden.

In einer weiteren, vorteilhaften Ausführungsform der vorliegenden Erfindung ist ein Widerstand zwischen Basisanschluß des Transistors des zweiten Schaltmittels und dem Anschluß für das Versorgungspotential angeschlossen. Der Widerstand kann vorteilhafterweise hochohmig ausgelegt sein und ermöglicht ein sicheres Abschalten des Transistors des zweiten Schaltmittels.

In einer weiteren, bevorzugten Ausführungsform der vorliegenden Erfindung kann anstelle des Widerstands ein Stromspiegel vorgesehen sein, welcher mit dem Anschluß für das Versorgungspotential und mit dem Basisanschluß des Transistors des zweiten Schaltmittels verbunden und mit dem Anschluß für die Hilfsspannung gekoppelt ist. Die Realisierung der sicheren Abschaltung des betreffenden, als Schaltverstärker ausgelegten Transistors mit weiteren Transistoren anstelle eines Widerstandes kann ein schnelleres Abschalten des Bipolar-Transistors ermöglichen.

In einer weiteren, vorteilhaften Ausführungsform der vorliegenden Erfindung umfassen die Ladungsspeicher jeweils zwei Polysilizium-Gebiete, welche durch ein Dielektrikum voneinander getrennt sind. Sogenannte Poly-Poly-Kapazitäten weisen einen besonders geringen Flächenbedarf auf und ermöglichen zudem eine Verschaltung mit ihrem ersten Anschluß an dem Anschluß für die Ausgangsspannung der Ladungspumpenschaltung, welcher eine zusätzliche Nutzung von Streukapazitäten gegen Substrat bzw. Bezugspotentialanschluß der Schaltung ermöglicht, welche beispielsweise 10% der Nennkapazität betragen können. Die Streukapazität zwischen erstem Ladungsspeicher und Bezugspotentialanschluß wirkt dabei als zusätzlicher Glättungskondensator.

Weitere Einzelheiten der Erfindung sind den Unteransprüchen entnehmbar.

Die Erfindung wird nachfolgend an mehreren Ausführungsbeispielen anhand der Zeichnungen näher erläutert.

Es zeigen:

Figur 1 ein Schaltbild einer ersten Ausführungsform der erfindungsgemäßen Ladungspumpenschaltung,

Figur 2 ein Schaltbild einer zweiten Ausführungsform der erfindungsgemäßen Ladungspumpenschaltung,

Figur 3 ein Schaltbild einer dritten Ausführungsform einer erfindungsgemäßen Ladungspumpenschaltung,

Figur 4 ein Schaltbild einer vierten Ausführungsform der erfindungsgemäßen Ladungspumpenschaltung,

Figur 5 ein Blockschaltbild einer fünften Ausführungsform der erfindungsgemäßen Ladungspumpenschaltung und

Figur 6 ein Blockschaltbild einer sechsten Ausführungsform der erfindungsgemäßen Ladungspumpenschaltung.

In den nachfolgenden Figurenbeschreibungen bezeichnen gleiche Bezugszeichen einander entsprechende Bauteile bzw. Funktionsblöcke.

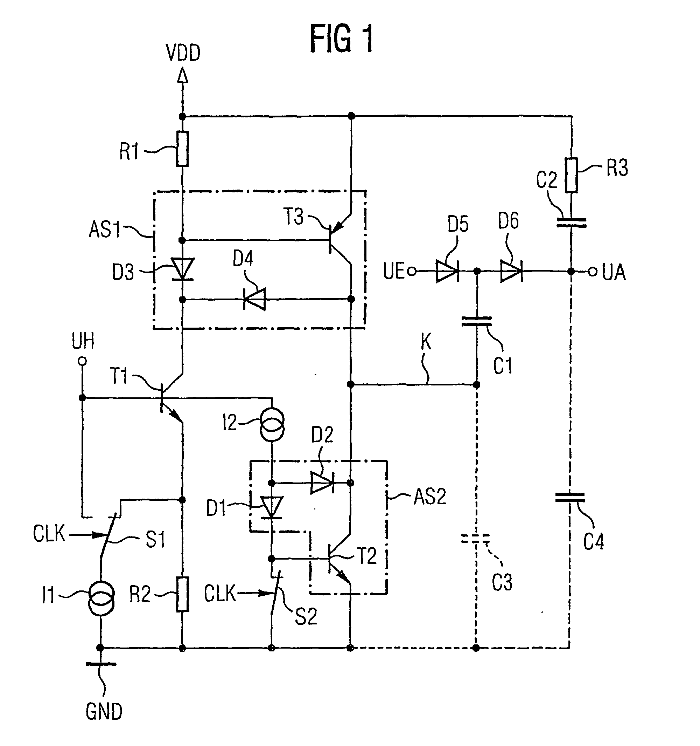

Figur 1 zeigt ein Schaltbild einer Ladungspumpenschaltung, welche eine Ausgangsspannung UA bereit stellt, die größer als die die Ladungspumpenschaltung versorgende Versorgungsspannung zwischen Versorgungspotential VDD und Bezugspotential GND ist. Ein erster Ladungsspeicher C1 ist einerseits über eine Diode D5 an einen Anschluß zur Zuführung einer Eingangsspannung UE und andererseits an einen Schaltungsknoten K angeschlossen. Der zweite Ladungsspeicher C2 ist einerseits über eine Diode D6 an den ersten Ladungsspeicher und andererseits über einen Widerstand R3 an den Anschluß für die Versorgungsspannung angeschlossen. Der Knoten K wird mit den als Schaltverstärker ausgeführten, in Emitterschaltung betriebenen Bipolar-Transistoren T2, T3 abwechselnd auf Versorgungsund Bezugspotential VDD, GND gelegt. Hierfür sind die Basisanschlüsse der Bipolar-Transistoren T2, T3 mit einem Anschluß zur Zuführung eines Hochfrequenz-Signals mit einer Pumpfrequenz CLK gekoppelt. Mit einer Ansteuerschaltung S1,S2 werden die Bipolar-Transistoren T2, T3 dabei so angesteuert, daß in einer ersten Taktphase, während das Hochfrequenz-Signal CLK gleich Null ist, der Transistor T2 ein- und der Transistor T3 ausgeschaltet bzw. gesperrt ist. Der Schaltungsknoten K liegt demnach praktisch auf Bezugspotential GND. Über Diode D5 wird der erste Ladungsspeicher C1 mit der Eingangsspannung UE aufgeladen. In einer zweiten Taktphase, d.h., wenn das Hochfrequenz-Signal CLK gleich Eins ist, sperrt der Transistor T2, während Transistor T3 eingeschaltet ist. Der Schaltungsknoten K ist folglich niederohmig mit dem Potential der Versorgungsspannung VDD und hochohmig mit dem Bezugspotential GND verbunden. Der Knoten K ist demnach während der zweiten Taktphase praktisch auf dem Potential der Versorgungsspannung VDD. Demnach wird die im Ladungsspeicher C1 gespeicherte Ladung über die in Flußrichtung gepolte Diode D6 in den zweiten Ladungsspeicher C2 übertragen. Es steht eine Ausgangsspannung UA zur Verfügung, welche der Summe aus Versorgungsspannung VDD und Eingangsspannung UE entspricht. Die Ausgangsspannung ist dabei höher als die Durchbruchsspannung eines einzelnen Ladungsspeichers C1, C2. Zwischen Ladungsspeicher C2 und Anschluß für Versorgungsspannung VDD ist ein Widerstand R3 vorgesehen, welcher den zweiten Ladungsspeicher C2 vor elektromagnetischen Einkopplungen oder elektrostatischen Entladungen schützt. Der zweite Ladungsspeicher C2 ist als Poly-Poly-Kapazität ausgebildet und mit seinem ersten Anschluß am Anschluß für die Ausgangsspannung UA angeschlossen, so daß die zwischen diesem Anschluß des zweiten Ladungsspeichers C2 und Substrat auftretende Streukapazität als zusätzliche Glättungskapazität C4 zwischen Anschluß für die Ausgangsspannung UA und Bezugspotential GND geschaltet ist. Eine zusätzliche, parasitäre Streukapazität C3 ist zwischen erstem Ladungsspeicher C1 und Bezugspotentialanschluß GND eingezeichnet.

An die Bipolar-Transistoren T2, T3 ist jeweils eine Anti-Sättigungsschaltung AS1, AS2 angeschlossen, welche die betreffenden Bipolar-Transistoren T2, T3 umfaßt. Diese Anti-Sättigungsschaltungen AS1, AS2 vermeiden dabei, daß die Transistoren T2, T3 in Sättigung gehen. Für den als PNP-Transistor ausgebildeten Bipolar-Transistor T3 sind zwei Dioden D3, D4 vorgesehen, welche mit ihren Kathodenanschlüssen miteinander verbunden sind und mit ihren Anodenanschlüssen mit dem Basisanschluß bzw. dem Kollektoranschluß des Transistors T3 verbunden sind. Am gemeinsamen Kathodenanschluß der Dioden D3, D4 ist eine Ansteuerschaltung zum Ansteuern des dritten Transistors T3 mit dem Hochfrequenz-Signal CLK angeschlossen. Der als NPN-Transistor ausgebildete Bipolar-Transistor T2 weist zur Verhinderung der Sättigung zwei Dioden D1, D2 auf, welche mit ihren Anodenanschlüssen miteinander verbunden sind und mit ihren Kathodenanschlüssen mit dem Basis- bzw. dem Kollektoranschluß des Transistors T2 verbunden sind. Auch der Transistor T2 ist mit der Ansteuerschaltung zu dessen Ansteuerung mit dem Hochfrequenz-Signal CLK verbunden.

Die Ansteuerschaltung zum Ansteuern der Transistoren T2, T3 mit dem Hochfrequenz-Signal CLK umfaßt einen ersten Schalter S1 sowie einen zweiten Schalter S2, welche mit dem Hochfrequenz-Signal CLK ansteuerbar sind, sowie eine erste und eine zweite Stromquelle I1, I2. Mit einem weiteren bipolaren NPN-Transistor T1, welcher steuerseitig an einen Hilfsspannungsanschluß UH angeschlossen ist, werden die Schalter S1,S2 sowie die Stromquellen I1, I2 vor hohen Spannungen geschützt und können folglich in strom- und flächensparender Weise aus Standard-CMOS-Bauelementen aufgebaut werden. Der Emitteranschluß des zusätzlichen Bipolar-Transistors T1 ist über einen Widerstand R2 mit Bezugspotential GND verbunden, um einen sehr geringen Ruhestrom, beispielsweise 1μA, durch den Transistor T1 einzustellen, um sicher zu stellen, daß die Emitter-Basis-Strecke des Hochvolt-NPN-Transistors T1 immer in Flußrichtung gepolt bleibt. Die Hilfsspannung UH ist bezüglich Schwankungen der Versorgungsspannung VDD stabilisiert.

Die beschriebene Ladungspumpenschaltung mit den beschriebenen Anti-Sättigungsschaltungen AS1, AS2 begrenzt in allen Betriebszuständen die Kollektor-Emitter-Spannung der Transistoren T2, T3 auf Spannungswerte größer 300mV, so daß mit dieser effektiven Sättigungsverhinderung der Stromverbrauch der Schaltungsanordnung um das Produkt aus der Sättigungsladung und der Pumpfrequenz des Hochfrequenz-Signals CLK reduziert ist. Zudem wird mit der beschriebenen Anti-Sättigungsschaltung eine Injektion von Substratstrom, insbesondere bei hohen Temperaturen, vermieden und somit der Stromverbrauch der Ladungspumpenschaltung weiter reduziert sowie der Temperaturgang verbessert. Die Ladungspumpenschaltung gemäß Figur 1 kann mit hohen Pumpfrequenzen, beispielsweise größer 1 MHz, betrieben werden, um eine Ausgangsspannung UA mit kleinem Innenwiderstand und geringem Spannungsrippel zu erzeugen. Die Eingangs- und Hilfsspannung UE,UH können gleich sein und beispielsweise 3 Volt betragen. Die Versorgungsspannung VDD kann mehrere 10 Volt groß sein. Der Widerstand R1, der zum sicheren Abschalten des Transistors T3 dient, ist hochohmig, beispielsweise mit einem Widerstandswert zwischen 50 und 100 kOhm auszulegen.

Die Bipolar-Transistoren T1, T2, T3 sowie die Dioden D2, D3, D4, D5, D6 sind hochvolttauglich auszulegen. Die Kapazitäten C1, C2 erfordern eine Spannungsfestigkeit in der Größenordnung der Eingangsspannung UE.

In der Anti-Sättigungsschaltung AS2 wird der den Transistor T2 ansteuernde Basisstrom durch Diode D2 abgeleitet, sobald die Kollektor-Basis-Spannung an T2 negativ wird. Da diese Rückkopplung lediglich über eine Diode D2, bzw. über eine Diode D4 in der Anti-Sättigungsschaltung AS1 erfolgt, wird die Reaktionszeit verbessert und Schwingungen der Regelanordnungen sind reduziert. Mit dem Schalter S2 bzw. dem Widerstand R1 werden die Transistoren T2 bzw. T3 sicher abgeschaltet.

Anstelle der Dioden D1, D3 können entweder Widerstände verwendet werden, mit denen sich die Spannungsdifferenz an den Kollektoranschlüssen der Transistoren T2, T3 beliebig einstellen läßt, oder es können anstelle der Dioden D1 bzw. D3 jeweils mehrere Dioden in Serie geschaltet sein, wobei sich die Spannungsdifferenz bzw. der Spannungshub an den Kollektoranschlüssen der Transistoren T2, T3 entsprechend verringert.

Die geringe Spannungsbelastung der Kapazitäten C1, C2 bei der beschriebenen Ladungspumpenschaltung ermöglicht eine geringe Ausfallhäufigkeit bzw. eine hohe Zuverlässigkeit der Schaltung.

Die Basisstrom-Ansteuerung der Bipolar-Transistoren T2, T3 ermöglicht die Erzielung eines großen Kollektorstromes der Transistoren T2, T3 zum Laden der Kondensatoren C1 und C3 mit geringen Basisströmen. Zur Erzielung eines Kollektorstromes am Transistor T3 von beispielsweise 300 Mikroampere ist bei einer Stromverstärkung β von 30 ein Basissteuerstrom von 10 Mikroampere erforderlich, womit man an dem am Knoten K angeschlossenen Kondensatoranschluß des Kondensators C1 eine Anstiegszeit von

$$T_r = \frac{C3 \cdot (VDD - 2 \cdot U_{BE})}{I_C} = 100ns$$

mit $T_r$ = Anstiegszeit, C3 = Kapazitätswert des Kondensators C3, $U_{BE}$ = Basis-Emitter-Spannung des Transistors T3, $I_c$ = Kollektorstrom am dritten Transistor T3 und mit C3 = 2pF, VDD = 17 V und $U_{BE}$ = 0,65 V. Ein weiterer Vorteil bezüglich der Gesamtstromverbrauchs-Reduzierung ergibt sich durch die gute Abschaltung der Transistoren T2, T3, bei denen im ausgeschalteten Zustand der Kollektorstrom gleich Null ist.

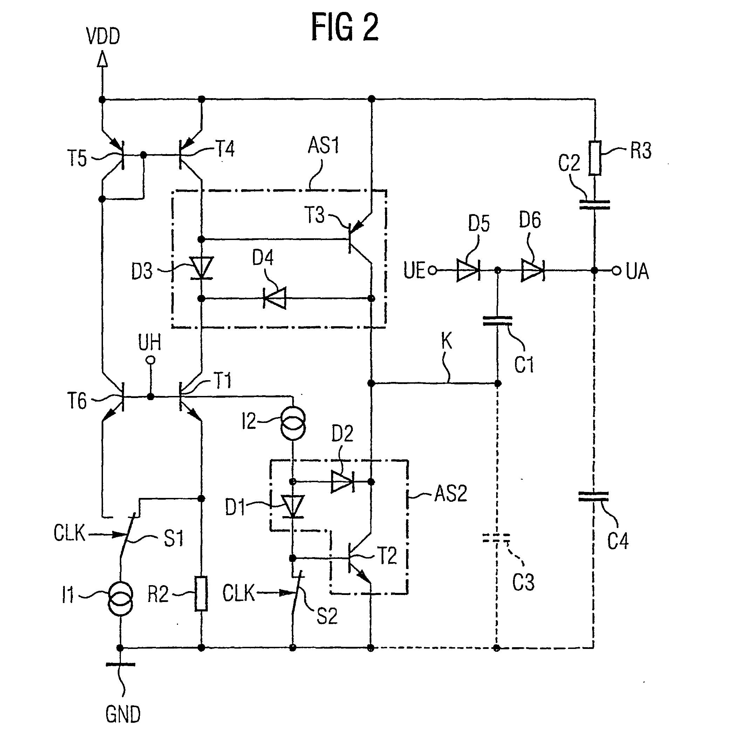

Figur 2 zeigt eine alternative Realisierung der Ladungspumpenschaltung und entspricht weitgehend der Schaltungsanordnung gemäß Figur 1, der Widerstand R1 ist hierbei jedoch mit einem Transistor T4 ersetzt, welcher mit einem weiteren Transistor T5 einen Stromspiegel bildet. Dieser Stromspiegel ist emitterseitig an die Versorgungsspannung VDD angeschlossen. Weiterhin ist ein Transistor T6 steuerseitig an die Hilfsspannung UH gelegt und lastseitig zum einen mit dem Schalter S1 und zum anderen mit dem Transistor T5 des Stromspiegels verbunden. Hierdurch wird die Sperrung des Transistors T3 im ausgeschalteten Zustand weiter verbessert, da über den Stromspiegel T4, T5 ein Basissteuerstrom eingeprägt wird, welcher die Basis des Transistors T3 effektiv sperrt. Zudem kann mit dem Stromspiegel T4, T5 gegenüber dem Widerstand R1 eine schnellere Abschaltung des Transistors T3 erzielt werden.

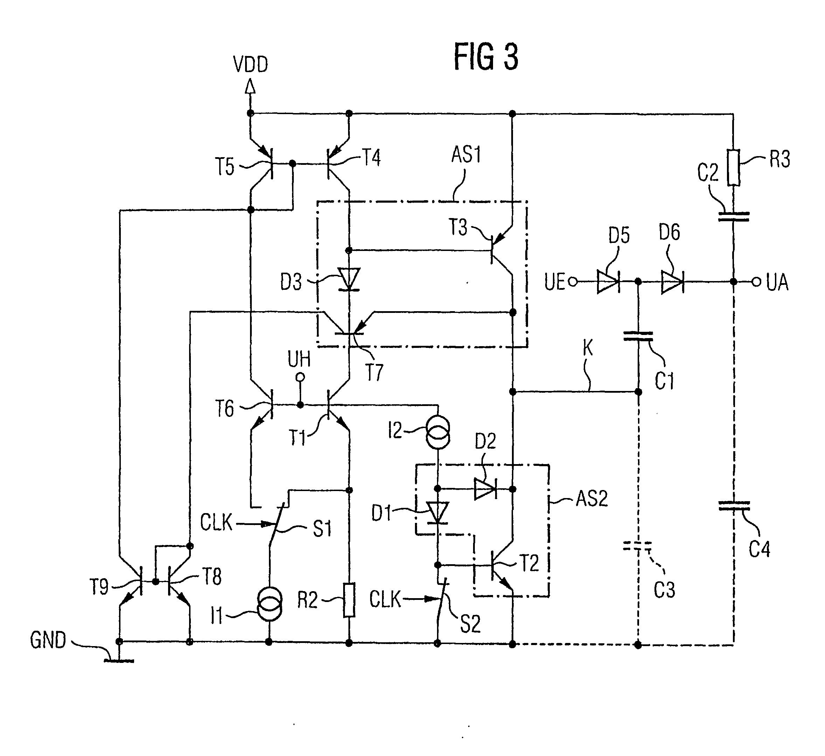

Eine weitere, alternative Realisierung der Ladungspumpenschaltung ist in Figur 3 anhand eines Blockschaltbildes dargestellt. Figur 3 unterscheidet sich von Figur 2 dadurch, daß anstelle der Diode D4 in der Anti-Sättigungsschaltung AS1 ein PNP-Transistor T7 vorgesehen ist. Dieser Transistor T7 ist mit seiner Basis an den Kathodenanschluß der Diode D3, mit seinem Emitter an den Kollektor des Transistors T3 und mit seinem Kollektor an einen zusätzlichen Stromspiegel T8, T9 angeschlossen. Der Stromspiegel T8, T9 ist emitterseitig an das Bezugspotential GND angeschlossen. Der Transistor T7 wird leitend, sobald das Kollektorpotential am Transistor T3 über dessen Basispotential ansteigt. Der dann durch Transistor T7 fließende Laststrom wird über die Stromspiegel T8, T9 sowie T4, T5 gespiegelt und schaltet den Transistor T3 aus. Demnach bilden die Transistoren T7, T8, T9, T4, T5 eine Regelschleife für Transistor T3.

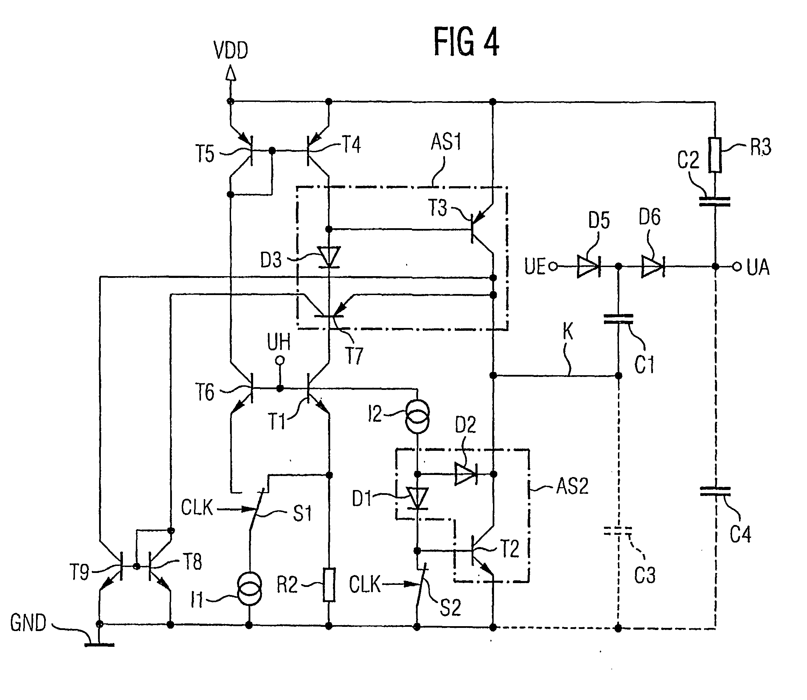

Figur 4 zeigt eine Weiterbildung der Ladungspumpenschaltung von Figur 3, bei der der Stromspiegel T8, T9 nicht an Transistor T7 und an Stromspiegel T4, T5 angeschlossen ist, sondern an Transistor T7 und kollektorseitig an Transistor T3. Eine derartige Realisierung der Anti-Sättigungsschaltung AS1 für den Transistor T3 bietet eine schnellere Rückkopplung, da die Regelschleife nurmehr aus drei Transistoren T7, T8, T9 besteht. Der Kollektorstrom des Transistors T7 wird nunmehr mit dem Stromspiegel T8, T9 stark vergrößert und unmittelbar aus dem Kollektor des Transistors T3 abgezogen.

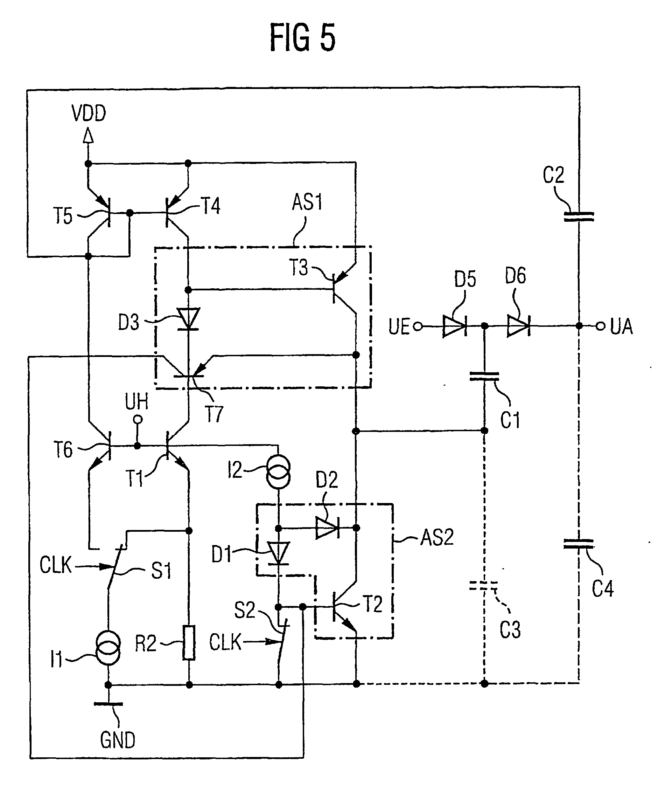

Eine weitere Schaltungsvariante der Ladungspumpenschaltung ist in Figur 5 angegeben. Figur 5 zeigt eine Weiterbildung der Ladungspumpenschaltung von Figur 4, bei der der Stromspiegel T8, T9 entfällt und der Kollektoranschluß des Transistors T7 nunmehr unmittelbar an den Basisanschluß des Transistors T2 geführt ist. Hierdurch wird die Regelschleife, welche nunmehr mit Transistoren T2, T7 gebildet ist, bezüglich ihrer Phasenreserve verbessert bei gegenüber Figur 4 gleichem Stromverbrauch. Diese Ladungspumpenschaltung ermöglicht eine sehr schnelle Abschaltung des Transistors T3 unter Nutzung des ohnehin vorhandenen Transistors T2, so daß der Stromspiegel T8, T9 entfallen kann. Ein weiterer Vorteil der Ladungspumpenschaltung gemäß Figur 5 ist dadurch gegeben, daß der den Kondensator C2 schützende Widerstand R3 entfallen kann und es somit möglich ist, den Kondensator C2 unmittelbar zwischen den Anschluß für die Ausgangsspannung UA und über Transistordiode T5 an die Versorgungsspannung VDD anzuschliesen. Alternativ hierzu könnte dieser Anschluß des Kondensators C2 auch an beliebige andere Schaltungspunkte der Ladungspumpenschaltung oder anderer Schaltungsteile im gleichen integrierten Schaltkreis gelegt werden, welche niederohmig mit Versorgungsspannung VDD verbunden sind.

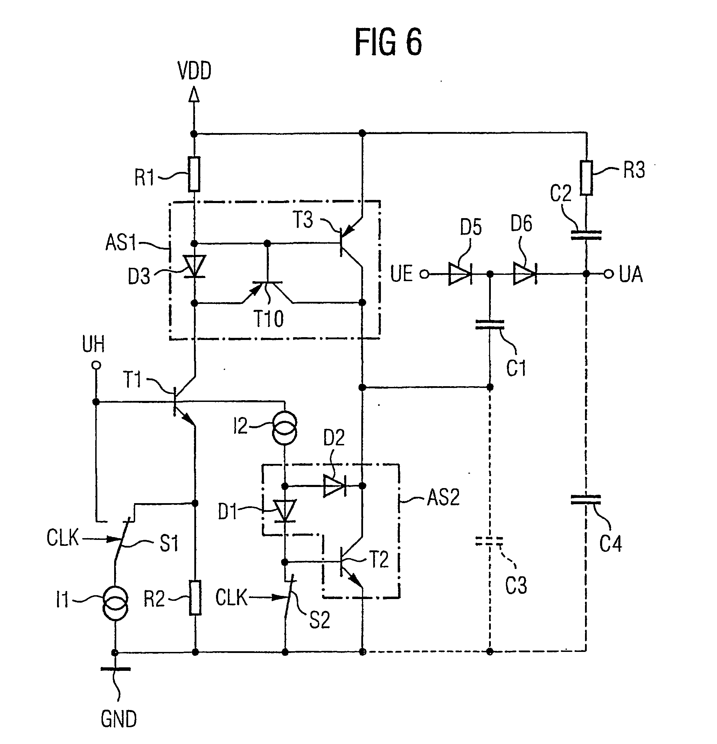

Schließlich zeigt Figur 6 ein letztes Ausführungsbeispiel der Ladungspumpenschaltung. Diese weist gegenüber Figur 1 den Unterschied auf, daß die Diode D4 durch einen Bipolar-PNP-Transistor T10 ersetzt ist, dessen Basisanschluß mit dem des Transistors T3, dessen Kollektoranschluß mit dem des Transistors T3 und dessen Emitteranschluß mit dem Kathodenanschluß der Diode D3 verbunden ist. Der Transistor T10 wird hierbei im inversen Betrieb eingesetzt, wodurch sich ebenfalls eine Sättigung des Transistors T3 verhindern läßt.

In weiteren alternativen Ausführungsformen kann die Diode D3 durch einen Widerstand ersetzt oder mit einem Widerstand in Serie ergänzt werden. In analoger Weise kann Diode D2 durch einen NPN-Transistor, vergleichbar mit der Beschaltung des Transistors T10, ersetzt werden. Weiterhin kann die Diode D1 in diesem Falle weggelassen werden, durch einen Widerstand ersetzt werden oder mit einem Serienwiderstand ergänzt werden.

Bezugszeichenliste

| AS1 | erste Anti-Sättigungsschaltung |
|-----|-------------------------------|
| AS2 | zweite Anti-Sättigungsschaltung |
| C1 | erster Ladungsspeicher |
| C2 | zweiter Ladungsspeicher |
| C3 | Zusatzkapazität |
| CLK | Hochfrequenz-Signal |
| GND | Bezugspotential |
| R1 | erster Widerstand |
| R2 | zweiter Widerstand |
| R3 | dritter Widerstand |
| S1 | erster Schalter |
| S2 | zweiter Schalter |
| T2 | zweites Schaltmittel |
| T3 | erstes Schaltmittel |
| UA | Ausgangsspannung |
| UE | Eingangsspannung |
| UH | Hilfsspannung |
| VDD | Versorgungspotential |

**Patentansprüche**

1. Ladungspumpenschaltung zur Bereitstellung einer Ausgangsspannung (UA), welche größer als eine Versorgungsspannung (VDD, GND) der Ladungspumpenschaltung ist, aufweisend

   - einen ersten Ladungsspeicher (C1), der einerseits über eine erste Diode (D5) mit einem Anschluß zur Zuführung einer Eingangsspannung (UE) und andererseits mit einem Schaltungsknoten (K) gekoppelt ist,
   - einen zweiten Ladungsspeicher (C2), der einerseits mit einem Anschluß zur Zuführung des Versorgungspotentials (VDD) und andererseits über eine zweite Diode (D6) mit dem ersten Ladungsspeicher gekoppelt, und mit einem Anschluß zur Bereitstellung der Ausgangsspannung (UA) verbunden ist,

- ein erstes Schaltmittel (T3), welches einerseits mit dem Versorgungspotentialanschluß (VDD) und andererseits mit dem Schaltungsknoten (K) gekoppelt ist und
- ein zweites Schaltmittel (T2), welches einerseits mit einem Anschluß für ein Bezugspotential (GND) und andererseits mit dem Schaltungsknoten (K) verbunden ist,
- wobei erstes und zweites Schaltmittel (T2, T3) Bipolar-Transistoren umfassen und zu deren Steuerung mit einem Anschluß zur Zuführung eines Hochfrequenz-Signals (CLK) gekoppelt sind.

2. Ladungspumpenschaltung nach Anspruch 1,
   **dadurch gekennzeichnet, daß**
   die erste Diode (D5) in Durchlaßrichtung zwischen dem Anschluß für die Eingangsspannung (UE) und dem ersten Ladungsspeicher (C1) und die zweite Diode (D6) in Durchlaßrichtung zwischen dem ersten Ladungsspeicher (C1) und dem zweiten Ladungsspeicher (C2) angeschlossen ist.

3. Ladungspumpenschaltung nach Anspruch 1 oder 2,
   **dadurch gekennzeichnet, daß**
   erstes und zweites Schaltmittel (T3, T2) je einen Bipolar-Transistor umfassen, an dem eine erste bzw. eine zweite Anti-Sättigungsschaltung (AS1, AS2) angeschlossen ist.

4. Ladungspumpenschaltung nach Anspruch 3,
   **dadurch gekennzeichnet, daß**
   an Steuereingänge der Bipolar-Transistoren (T2, T3) eine Ansteuerschaltung (S1, S2) angeschlossen ist, der das Hochfrequenz-Signal (CLK) zuführbar ist zum abwechselnden Einschalten der als Schaltverstärker ausgelegten Bipolar-Transistoren (T2, T3).

5. Ladungspumpenschaltung nach Anspruch 4,
   **dadurch gekennzeichnet, daß**
   ein Mittel zum Schutz vor hohen Spannungen (T1) vorgesehen ist, welchem an einem Steuereingang eine Hilfsspannung (UH) zuführbar ist und welches die Ansteuerschaltung (S1, S2) mit dem Anschluß für die Versorgungsspannung (VDD) verbindet.

6. Ladungspumpenschaltung nach Anspruch 4 oder 5,
   **dadurch gekennzeichnet, daß**
   die Anti-Sättigungsschaltungen (AS1, AS2) je zwei gegeneinander geschaltete Dioden (D1, D2; D3, D4) umfassen, welche zwischen Basisanschluß und Kollektoranschluß der Bipolar-Transistoren (T2, T3) angeschlossen sind, wobei die Anti-Sättigungsschaltungen (AS1, AS2) mit der Ansteuerschaltung (S1, S2) verbunden sind.

7. Ladungspumpenschaltung nach Anspruch 6,
   **dadurch gekennzeichnet, daß**
   ein Widerstand (R1) zwischen Basisanschluß des Bipolar-Transistors (T3) und Anschluß für das Versorgungspotential (VDD) angeschlossen ist.

8. Ladungspumpenschaltung nach Anspruch 6,
   **dadurch gekennzeichnet, daß**
   ein Stromspiegel (T4, T5) an dem Basisanschluß des Transistors (T3) und an die Versorgungsspannung (VDD) angeschlossen und mit dem Anschluß für die Hilfsspannung (UH) gekoppelt ist.

9. Ladungspumpenschaltung nach einem der Ansprüche 1 bis 8,
   **dadurch gekennzeichnet, daß**
   die Ladungsspeicher (C1, C2) jeweils 2 Polysilizium-Gebiete umfassen, welche durch ein Dielektrikum voneinander getrennt sind.

**Claims**

1. Charge pump circuit for providing an output voltage (UA) which is greater than a supply voltage (VDD, GND) of the charge pump circuit, having

   - a first charge store (C1), which is coupled, on the one hand, via a first diode (D5) to a terminal for feeding in an input voltage (UE) and, on the other hand, to a circuit node (K),
   - a second charge store (C2), which is coupled, on the one hand, to a terminal for feeding in the supply potential (VDD) and, on the other hand, via a second diode (D6) to the first charge store, and is connected to a terminal for providing the output voltage (UA),
   - a first switching means (T3), which is coupled, on the one hand, to the supply potential terminal (VDD) and, on the other hand, to the circuit node (K), and
   - a second switching means (T2), which is connected, on the one hand, to a terminal for a reference-ground potential (GND) and, on the other hand, to the circuit node (K),
   - first and second switching means (T2, T3) comprising bipolar transistors and, for the control thereof, being coupled to a terminal for feeding in a high-frequency signal (CLK).

2. Charge pump circuit according to Claim 1,
   **characterized in that**
   the first diode (D5) is connected in the forward direction between the terminal for the input voltage (UE) and the first charge store (C1) and the second diode (D6) is connected in the forward direction between the first charge store (C1) and the second charge store (C2).

3. Charge pump circuit according to Claim 1 or 2, **characterized in that**
first and second switching means (T3, T2) each comprise a bipolar transistor to which a first and, respectively, a second anti-saturation circuit (AS1, AS2) is connected.

4. Charge pump circuit according to Claim 3, **characterized in that**
a drive circuit (S1, S2) is connected to control inputs of the bipolar transistors (T2, T3), to which drive circuit the high-frequency signal (CLK) can be fed for alternately switching on the bipolar transistors (T2, T3) designed as switching amplifiers.

5. Charge pump circuit according to Claim 4, **characterized in that**
a means for protection against high voltages (T1) is provided, to which an auxiliary voltage (UH) can be fed at a control input and which connects the drive circuit (S1, S2) to the terminal for the supply voltage (VDD).

6. Charge pump circuit according to Claim 4 or 5, **characterized in that**
the anti-saturation circuits (AS1, AS2) each comprise two diodes (D1, D2; D3, D4) which are connected back to back and are connected between base terminal and collector terminal of the bipolar transistors (T2, T3), the anti-saturation circuits (AS1, AS2) being connected to the drive circuit (S1, S2).

7. Charge pump circuit according to Claim 6, **characterized in that**
a resistor (R1) is connected between base terminal of the bipolar transistor (T3) and terminal for the supply potential (VDD).

8. Charge pump circuit according to Claim 6, **characterized in that**
a current mirror (T4, T5) is connected to the base terminal of the transistor (T3) and to the supply voltage (VDD) and is coupled to the terminal for the auxiliary voltage (UH).

9. Charge pump circuit according to one of Claims 1 to 8,
**characterized in that**
the charge stores (C1, C2) in each case comprise two polysilicon regions which are isolated from one another by a dielectric.

**Revendications**

1. Circuit à pompe de charge pour mettre à disposition une tension (UA) de sortie qui est plus grande qu'une tension (VDD, GND) d'alimentation du circuit à pompe de charge comportant

   - un premier accumulateur (C1) de charge, qui est couplé d'une part par une première diode (D5) à une borne d'application d'une tension (DE) d'entrée et d'autre part à un noeud (K) de circuit ;
   - un deuxième accumulateur (C2) de charge, qui est couplé d'une part à une borne d'application du potentiel (VDD) d'alimentation et d'autre part par une deuxième diode (D6) au premier accumulateur de charge et qui est relié à une borne de mise à disposition de la tension (UA) de sortie ;
   - un premier moyen (T3) de commutation, qui est couplé d'une part à la borne (VDD) du potentiel d'alimentation et d'autre part au noeud (K) de circuit ; et
   - un deuxième moyen (T2) de commutation, qui est relié d'une part à une borne pour un potentiel (GND) de référence et d'autre part au noeud (K) de circuit ;
   - le premier et le deuxième moyens (T2, T3) de commutation comprenant des transistors bipolaires et étant couplés pour leur commande à une borne d'application d'un signal (CLK) de haute fréquence.

2. Circuit à pompe de charge suivant la revendication 1, **caractérisé en ce que** la première diode (D5) est montée dans le sens passant entre la borne pour la tension (UE) d'entrée et le premier accumulateur (C1) de charge et la deuxième diode (D6) dans le sens passant entre le premier accumulateur (C1) de charge et le deuxième accumulateur (C2) de charge.

3. Circuit à pompe de charge suivant la revendication 1 ou 2, **caractérisé en ce que** le premier et le deuxième moyens (T3, T2) de commutation comprennent chacun un transistor bipolaire auquel est relié un premier et un deuxième circuit (AS1, AS2) d'antisaturation.

4. Circuit à pompe de charge suivant la revendication 3, **caractérisé en ce qu'**aux entrées de commande des transistors (T2, T3) bipolaires est raccordé un circuit (S1, S2) de commande auquel peut être envoyé le signal (CLK) de haute fréquence pour la mise en circuit alternée des transistors (T2, T3) bipolaires conçus en tant qu'amplificateur de commutation.

5. Circuit à pompe de charge suivant la revendication 4, **caractérisé en ce qu'**il est prévu un moyen de protection vis-à-vis des hautes tensions (T1) auquel peut être appliquée sur une entrée de commande une tension (UH) auxiliaire et qui relie le circuit (S1, S2) de commande à la borne pour la tension (VDD) d'alimentation.

6. Circuit à pompe de charge suivant la revendication 4 ou 5, **caractérisé en ce que** les circuits (AS1, AS2) d'antisaturation comprennent, respectivement, deux diodes (D1, D2 ; D3, D4) montées tête-bêche qui sont raccordées entre la borne de base et la borne de collecteur des transistors (T2, T3) bipolaires, les circuits (AS1, AS2) d'antisaturation étant reliés au circuit (S1, S2) de commande.

7. Circuit à pompe de charge suivant la revendication 6, **caractérisé en ce qu'**une résistance (R1) est raccordée entre la borne de base du transistor (T3) bipolaire et la borne pour le potentiel (VDD) d'alimentation.

8. Circuit à pompe de charge suivant la revendication 6, **caractérisé en ce qu'**un miroir de courant (T4, T5) est raccordé à la borne de base du transistor (T3) et à la tension (VDD) d'alimentation et est couplé à la borne pour la tension (UH) auxiliaire.

9. Circuit à pompe de charge suivant l'une des revendications 1 à 8, **caractérisé en ce que** les accumulateurs (C1, C2) de charge comprennent, respectivement, deux zones en polysilicium qui sont séparées l'une de l'autre par un diélectrique.

EP 1 317 793 B1

# FIG 1

10

# FIG 2

FIG 3

EP 1 317 793 B1

# FIG 4

EP 1 317 793 B1

# FIG 5

14

# FIG 6